Europäisches Patentamt

European Patent Office

Office européen des brevets

(19)

(11) Veröffentlichungsnummer: **0 137 942**
**B1**

(12) **EUROPÄISCHE PATENTSCHRIFT**

(45) Veröffentlichungstag der Patentschrift:
**11.03.87**

(51) Int. Cl.⁴: **G 01 R 21/00,** G 01 R 15/08

(21) Anmeldenummer: **84109254.7**

(22) Anmeldetag: **03.08.84**

(54) **Elektronischer Elektrizitätszähler mit automatischer Messbereichserweiterung.**

(30) Priorität: **17.08.83 DE 3329761**

(43) Veröffentlichungstag der Anmeldung:
**24.04.85 Patentblatt 85/17**

(45) Bekanntmachung des Hinweises auf die Patenterteilung:
**11.03.87 Patentblatt 87/11**

(84) Benannte Vertragsstaaten:
**AT CH DE FR GB IT LI SE**

(56) Entgegenhaltungen:
**DE - A - 2 539 344**
**DE - A - 2 951 627**

(73) Patentinhaber: **Siemens Aktiengesellschaft Berlin und München, Wittelsbacherplatz 2, D-8000 München 2 (DE)**

(72) Erfinder: **Schwendtner, Manfred, Dipl.-Ing., St. Gundekarstrasse 3, D-8501 Schwarzenbruck (DE)**
Erfinder: **Steinmüller, Günter, Dipl.-Ing., Laufamholzstrasse 65, D-8500 Nürnberg (DE)**

### Beschreibung

Die Erfindung betrifft einen elektronischen Elektrizitätszähler mit einem Multiplizierer für Strom und Spannung wobei dem Multiplizierer ein Quantisierer mit umschaltbarem Umsetzungsverhältnis und eine Zähleinrichtung nachgeschaltet ist und wobei dem Stromeingang des Multiplizierers ein Eingangskreis mit umschaltbarem Übersetzungsverhältnis vorgeschaltet ist.

Bei elektronischen Zählern ist der Einfluss von Offset-Spannungen und Offset-Strömen nicht mehr zu vernachlässigen, wenn die gemessene Leistung einen bestimmten Bruchteil der Nennleistung unterschreitet. Im allgemeinen treten grössere Messfehler auf, wenn die gemessene Leistung kleiner als 1 % der Nennleistung ist. Insbesondere bei der Verrechnung grosser Energiemengen wird jedoch angestrebt, dass der Messfehler auch bei einer bezüglich der Nennleistung sehr kleinen Leistung gering bleibt.

Bei einem aus der DE-OS 2 539 344 bekannten Elektrizitätszähler der eingangs genannten Art wird der Eingangskreis, in diesem Fall ein Strom-Spannungswandler, sowie der Quantisierer in Abhängigkeit vom Momentanwert des gemessenen Stromes umgeschaltet. Bei zunehmendem Strom wird das Übersetzungsverhältnis des Strom-Spannungswandlers so verändert, dass die Eingangsspannung des Multiplizierers bei vorgegebenem Strom verkleinert wird. Dies wird dadurch kompensiert, dass das Umsetzungsverhältnis des Quantisierers invers dazu verändert wird, so dass die Zähleinrichtung die aufgenommene Energie weiterhin richtig registriert. Durch die automatische Messbereichseinstellung soll der Dynamikbereich sowie der Signal-Rauschabstand des Elektrizitätszählers verbessert werden.

Mit einer derartigen Messbereichsumschaltung werden die Fehler des Multiplizierers und des Quantisierers bei kleinen Leistungen verringert. Die Umschaltung in Abhängigkeit vom aufgenommenen Strom kann dabei jedoch nicht befriedigen. Der genannte Fehler hängt nämlich nicht direkt vom Strom, sondern von der gemessenen Leistung ab. Zwischen Strom und Leistung besteht jedoch auch bei fester Spannung kein direkter Zusammenhang, da die Leistung auch vom variablen Leistungsfaktor abhängig ist. Weitere Nachteile zeigen sich dann, wenn die bekannte Anordnung für Drehstromzähler verwendet werden soll. Hierbei wären dann drei Stromvergleichseinrichtungen erforderlich und zusätzlich eine Auswerteschaltung, die feststellt, wann eine Umschaltung erfolgen soll.

Aufgabe der Erfindung ist es daher, einen elektronischen Elektrizitätszähler der eingangs genannten Art so zu realisieren, dass die Messbereichsumschaltung exakter den tatsächlichen Erfordernissen angepasst wird und dass auch bei Drehstromzählern der Aufwand gering bleibt.

Diese Aufgabe wird erfindungsgemäss dadurch gelöst, dass dem Quantisierer eine Auswertestufe für die Taktperiode seiner Ausgangsspannung nachgeschaltet ist und dass die Auswertestufe den Eingangskreis und den Umschalteingang des Quantisierers so steuert, dass über einem Grenzwert der Taktperiode das Eingangssignal des Stromeingangs des Multiplizierers vergrössert und das Umsetzungsverhältnis des Quantisierers so weit erhöht wird, dass die Wirkung der Eingangssignalvergrösserung kompensiert wird.

Bei der erfindungsgemässen Anordnung wird also bei kleinen Leistungswerten das Eingangssignal des Multiplizierers erhöht, so dass dessen Fehler verringert wird. Dies gilt auch für die Fehler des nachgeschalteten Quantisierers. Als Umschaltkriterium wird in einfacher Weise die leistungsproportionale Taktperiode des Quantisierers verwendet. Auch bei Drehstromzählern ist nur ein Quantisierer vorhanden, so dass man mit der Bildung eines einzigen Umschaltkriteriums für alle drei Phasen auskommt.

Der Eingangskreis kann aus zwei Bürdenwiderständen bestehen, die — gesteuert durch die Auswertestufe — mit der Sekundärseite des Stromwandlers verbindbar sind. Dadurch ist eine besonders einfache Möglichkeit zur Anpassung des Eingangssignals gegeben.

Die Auswertestufe kann ein erstes Monoflop enthalten, das mit jeder positiven oder negativen Flanke des Ausgangssignals des Quantisierers angestossen wird, wobei durch Überprüfung des Ausgangssignalzustandes bei Ablauf der durch das Monoflop vorgegebenen Impulsdauer die Taktperiode des Ausgangssignals überprüft wird.

Die Auswertestufe kann ausserdem ein zweites Monoflop enthalten, das mit derselben Flanke des Ausgangssignals des Quantisierers angestossen wird, wobei durch Überprüfung des Ausgangssignalzustandes bei Ablauf der durch das zweite Monoflop vorgegebenen Impulsdauer ebenfalls die Taktperiode des Ausgangssignals überprüft wird, wobei die durch das zweite Monoflop vorgegebene Impulsdauer kürzer ist als die durch das erste Monoflop vorgegebene Impulsdauer und wobei die Vergrösserung des Eingangssignals des Stromeingangs des Multiplizierers durch das erste Monoflop ausgelöst und durch das zweite Monoflop wieder aufgehoben wird. Damit wird eine Hysterese im Umschaltverhalten erzeugt, die ein ständiges Hin- und Herschalten bei Schwankungen der Taktperiodendauer um einen Umschaltpunkt verhindert.

Der Ausgang jedes Monoflops kann mit dem D-Eingang je eines D-Flip-Flops verbunden sein, wobei das Ausgangssignal des Quantisierers über einen Inverter dem Takteingang jedes D-Flip-Flops zugeführt ist, wobei ein Ausgang jedes D-Flip-Flops mit je einem Eingang eines RS-Flip-Flops verbunden ist und wobei ein Ausgang des RS-Flip-Flops den umschaltbaren Eingangssignalteiler und den umschaltbaren Frequenzteiler ansteuert.

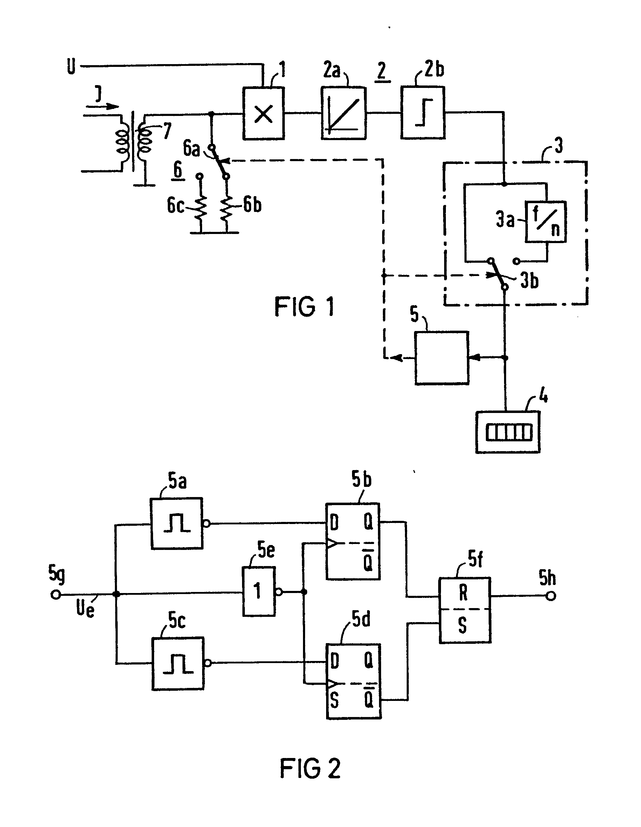

Ein Ausführungsbeispiel der Erfindung wird nachfolgend anhand der Figuren 1 bis 7 näher erläutert.

Fig. 1 zeigt ein Blockschaltbild des erfindungsgemässen Elektrizitätszählers.

Der Messstrom I wird über einen Stromwandler 7 auf für die Elektronik geeignete Werte herabgesetzt. Die Sekundärwicklung des Stromwandlers 7 ist mit dem Stromeingang eines Multiplizierers 1 und mit einem Umschalter 6a verbunden. Die beiden Kontakte des Umschalters 6a sind mit einem ersten Bürdenwiderstand 6b bzw. einem zweiten Bürdenwiderstand 6c verbunden. Damit kann bei gleichem Messstrom die Eingangsspannung des Stromeingangs des Multiplizierers 1 umgeschaltet werden. Der Umschalter 6a stellt also zusammen mit den Bürdenwiderständen 6b und 6c einen Eingangskreis 6 mit umschaltbarem Übersetzungsverhältnis dar.

Dem zweiten Eingang des Multiplizierers 1 wird die Messspannung U zugeführt. Dem Multiplizierer 1 ist ein Quantisierer 2 nachgeschaltet, der die vom Multiplizierer 1 gelieferte Ausgangsspannung in eine Impulsfolge umwandelt, deren Frequenz der Ausgangsspannung des Multiplizierers 1 proportional ist. Der Quantisierer 2 besteht aus einem Integrierer 2a, einer Grenzwertstufe 2b und einem umschaltbaren Frequenzteiler 3. Der Ausgang des Quantisierers 2 ist mit einer Zähleinrichtung 4 verbunden. Der umschaltbare Frequenzteiler 3 enthält einen Umschalter 3b, mit dem sein Eingang entweder direkt oder über einen Frequenzteiler 3a, mit dem Ausgang verbindbar ist. Die Umschalter 3b und 6a werden von einer noch näher zu erläuternden Auswertestufe 5 angesteuert.

Bezüglich des Aufbaus von Multiplizierer 1 und Quantisierer 2 wird auf den Artikel «Ein genauer elektronischer Elektrizitätszähler» in der Zeitschrift «Technisches Messen atm» 1978, Heft 11, Seiten 407 bis 411 verwiesen, wo verschiedene Schaltungsmöglichkeiten dargestellt sind.

Der dargestellte Elektrizitätszähler wird im Normalbetrieb mit den dargestellten Stellungen der Umschalter 3b und 6a betrieben. Der Frequenzteiler 3a ist also nicht in Betrieb. Der Bürdenwiderstand 6b ist wirksam, wobei dieser einen kleineren Widerstandswert als der Bürdenwiderstand 6c aufweist.

Wenn die gemessene Leistung sehr klein wird, beispielsweise unter 1% der Nennleistung sinkt, so nimmt der Fehler des Elektrizitätszählers vor allem aufgrund von Offset-Spannungen und -Strömen des Multiplizierers 1 und des Integrierers 2a stark zu, wenn man nicht die im folgenden beschriebenen Massnahmen ergreift.

Mit der Auswertestufe 5 wird die Taktperiode des Ausgangssignals des umschaltbaren Frequenzteilers 3 überwacht. Wenn die gemessene Leistungs kleiner wird, so wird die Taktperiode länger. Wenn die Taktperiode eine vorgegebene Dauer überschreitet, d.h. wenn die gemessene Leistungs unter einen bestimmten Grenzwert sinkt, so werden durch die Auswertestufe 5 die Umschalter 6a und 3b umgeschaltet. Da der nunmehr zur Geltung kommende Bürdenwiderstand 6c einen höheren Widerstandswert aufweist als der Bürdenwiderstand 6b wird das Eingangssignal am Stromeingang des Multiplizierers 1 bei gleichbleibendem Messstrom I erhöht. Entsprechend verursachen die Offset-Spannungen und -Ströme des Multiplizierers 1 und des Quantisierers 2 geringere Fehler. Die Erhöhung des am Stromwandler 7 wirksamen Bürdenwiderstands hat bei gleicher Leistung eine höhere Impulsrate am Ausgang des Quantisierers zur Folge. Diese erhöhte Impulsrate wird mit dem Frequenzteiler 3a wieder so weit herabgesetzt, dass die Erhöhung des Bürdenwiderstands kompensiert wird.

Fig. 1 zeigt eine einphasige Darstellung des Elektrizitätszählers. Selbstverständlich kann auch ein Drehstrom-Elektrizitätszähler entsprechend aufgebaut werden, wobei lediglich der gesamte Eingangskreis einschliesslich des Multiplizierers 1 dreiphasig sein muss. Der Integrator 2a kann auch als Addierer für die drei Phasen verwendet werden. Ein Ausführungsbeispiel für die Auswertestufe 5 ist in Fig. 2 dargestellt. Das an der Eingangsklemme 5g anstehende Ausgangssignal des umschaltbaren Frequenzteilers 3 wird zwei Monoflops 5a und 5c zugeführt. Die invertierenden Ausgänge der Monoflops 5a und 5c sind jeweils dem D-Eingang eines D-Flip-Flops 5b bzw. 5d zugeführt. Ferner ist die Eingangsklemme 5g über einen Inverter 5e mit den Takteingängen der D-Flip-Flops 5b und 5d verbunden. Der Setzausgang des D-Flip-Flops 5b bzw. der Rücksetzausgang des D-Flip-Flops 5d sind mit dem Rücksetzeingang bzw. dem Setzeingang eines RS-Flip-Flops 5f verbunden. Der Setzausgang des RS-Flip-Flops 5f ist mit der Ausgangsklemme 5h der Auswertestufe 5 verbunden, d.h. er steuert die Umschalter 3b und 6a.

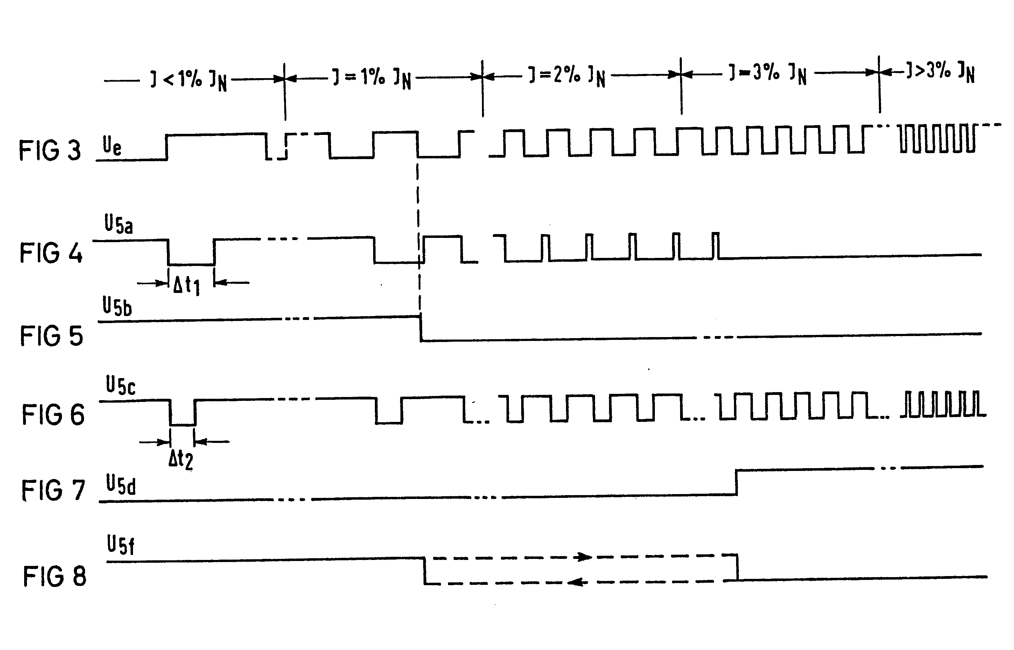

Die Funktion der Schaltung nach Fig. 2 wird im folgenden anhand der Impulsdiagramme nach den Fig. 3 bis 8 näher erläutert.

Fig. 3 zeigt die vom umschaltbaren Frequenzteiler 3 gelieferte Eingangsspannung $U_e$ der Auswerteschaltung 5.

Dabei sind fünf Bereiche des Messstroms I in Relation zum Nennstrom $I_N$ unterschieden, nämlich:

$$I < 1\% \ I_N \quad I = 1\% I_N \quad I > 2\% \ I_N \quad I = 3\% \ I_N \quad I > 3\% \ I_N$$

Dabei erkennt man, dass die Frequenz der vom umschaltbaren Frequenzteiler 3 gelieferten Taktimpulse proportional zum Messstrom I zunimmt, d.h. die Taktperiode umgekehrt proportional abnimmt. Das Ein-/Aus-Verhältnis der Taktimpulse bleibt dabei 1:1. Vorausgesetzt ist dabei jeweils ein konstanter Leistungsfaktor.

Fig. 4 zeigt die Ausgangsspannung $U_{5a}$ des Monoflops 5a im zeitlichen Zusammenhang mit der Eingangsspannung $U_e$. Das Monoflop 5a wird mit jeder positiven Flanke von $U_e$ angestossen, wobei der invertierende Ausgang für eine definierte Dauer $\triangle t_1$ auf Null geht.

Diese Impulse werden dem D-Eingang des D-Flip-Flops 5b zugeführt, das mit den negativen Flanken der Eingangsspannung $U_e$ getastet wird. Wie die Fig. 3 bis 5 zeigen, ist im Bereich $I < 1\% \ I_N$ die Ausgangsspannung $U_{5a}$ bei den negativen Flanken der Eingangsspannung $U_e$ stets «1», so dass auch die Ausgangsspannung $U_{5b}$ des D-Flip-Flops «1» bleibt. Die vom Monoflop 5a vorgegebene Impulsdauer ist so festgelegt, dass sie gleich der Dauer eines «1»-Impulses der Eingangsspannung $U_e$ bei $I = 1\% \ I_N$ ist. Wenn I 1% $I_N$ überschreitet ist also bei jeder negativen Flanke der Eingangsspannung $U_e$ die Ausgangsspannung $U_{5a}$ des Monoflops 5a noch nicht auf «1», so dass die Ausgangsspannung $U_{5b}$ des D-Flip-Flops auf «0» zurückgestellt wird. Dieser Signalpegel bleibt erhalten, wenn I weiter ansteigt. Mit dem Monoflop 5a und dem D-Flip-Flop 5b wird also ermittelt, ob der Messstrom I bzw. die Leistung grösser oder kleiner als 1% des Nennstroms $I_N$ bzw. der Nennleistung ist.

In Fig. 6 ist das Ausgangssignal $U_{5c}$ des Monoflops 5c dargestellt. Auch dieses wird durch die ne-

gativen Flanken der Eingangsspannung $U_e$ angestossen, so dass der Ausgang für eine Zeit $\Delta t_2$ wegen der Inversion am Ausgang auf Null geht. Dabei gilt im Ausführungsbeispiel:

$$\Delta t_2 = 1/3 \, \Delta t_1$$

Die Zeitdauer $t_2$ ist ferner gleich der Länge eines Impulses der Eingangsspannung $U_e$, wenn der Messstrom $I = 3\% \, I_N$ ist. Das D-Flip-Flop 5d wird ebenfalls mit den negativen Flanken der Eingangsspannung $U_e$ getriggert. Solange der Messstrom I kleiner als $3\% \, I_N$ ist, d.h. solange die Impulsdauer $\Delta t_2$ kürzer als ein Takt der Eingangsspannung $U_e$ ist, bleibt das D-Flip-Flop 5d in seiner Setzstellung, d.h. am Ausgang $\overline{Q}$ steht «0» an. Wird dagegen der Messstrom I grösser als $3\% \, I_N$, so geht das Signal $U_{5d}$ am Ausgang $\overline{Q}$ des D-Flip-Flops 5d auf «1». Mit dem Monoflop 5c und dem D-Flip-Flop 5d wird also überprüft, ob der Messstrom I grösser als 3% des Nennstroms $I_N$ ist.

Wenn der Messstrom I von Werten unter 1% des Nennstroms $I_N$ auf Werte über 3% des Nennstroms steigt, so wird über das D-Flip-Flop 5b das RS-Flip-Flop 5f in Rücksetzstellung gebracht, am Ausgang 5h der Auswerteschaltung 5 steht also ein «1»-Signal an. Erst bei Messstromwerten I ab $3\% \, I_N$ wird durch das D-Flip-Flop 5d das RS-Flip-Flop 5f in die Setzstellung gebracht, der Ausgang 5h führt also «0»-Signal.

Wenn umgekehrt der Messstrom I von Werten grösser $3\% \, I_N$ auf Werte unter $1\% \, I_N$ sinkt, so ist das RS-Flip-Flop 5f zunächst in Rücksetzstellung. Erst wenn das D-Flip-Flop 5b gesetzt wird, d.h. bei Leistungswerten unter 1% der Nennleistung, so wird auch das RS-Flip-Flop 5f zurückgesetzt.

Am Ausgang 5h der dargestellten Auswertestufe 5 steht also ein Signal zur Verfügung, das bei Messstromwerten I kleiner $1\% \, I_N$ «Eins» wird und wieder auf «Null» geht, wenn der Messstrom I grösser 3% $I_N$ wird. Mit diesem Signal werden die Umschalter 6a und 3b angesteuert. Dabei hat die grosse Hysterese den Vorteil, dass ein ständiges Hin- und Herschalten der Umschalter 6a und 3b vermieden wird, wenn der Messstrom I um kleine Werte schwankt.

**Patentansprüche**

1. Elektronischer Elektrizitätszähler mit einem Multiplizierer (1) für Strom und Spannung, wobei dem Multiplizierer (1) ein Quantisierer (2, 3) mit umschaltbarem Umsetzungsverhältnis und eine Zähleinrichtung (4) nachgeschaltet ist und wobei dem Stromeingang des Multiplizierers ein Eingangskreis (6) mit umschaltbarem Übersetzungsverhältnis vorgeschaltet ist, dadurch gekennzeichnet, dass dem Quantisierer (2, 3) eine Auswertestufe (5) für die Taktperiode seiner Ausgangsspannung nachgeschaltet ist und dass die Auswertestufe (5) den Eingangskreis (6) und den Umschalteingang des Quantisierers (2, 3) so ansteuert, dass über einem Grenzwert der Taktperiode das Eingangssignal des Stromeingangs des Multiplizierers (1) vergrössert und das Umsetzungsverhältnis des Quantisierers (2, 3) so weit erhöht wird, dass die Wirkung der Eingangssignalvergrösserung kompensiert wird.

2. Elektronischer Elektrizitätszähler nach Anspruch 1, mit einem dem Stromeingang des Multiplizierers (1) vorgeschalteten Stromwandler (7), dadurch gekennzeichnet, dass der Eingangskreis (6) aus zwei Bürdenwiderständen (6b, 6c) besteht, die, gesteuert durch die Auswertestufe (5), mit der Sekundärseite des Stromwandlers (7) verbindbar sind.

3. Elektronischer Elektrizitätzähler nach Anspruch 1 oder 2, dadurch gekennzeichnet, dass die Auswertestufe (5) ein erstes Monoflop (5a) enthält, das mit jeder positiven oder negativen Flanke des Ausgangssignals des Quantisierers (2, 3), angestossen wird und dass durch Überprüfung des Ausgangssignalzustandes bei Ablauf der durch das Monoflop (5a) vorgegebenen Impulsdauer ($\Delta t_1$) die Taktperiode des Ausgangssignals überprüft wird.

4. Elektronischer Elektrizitätszähler nach Anspruch 3, dadurch gekennzeichnet, dass die Auswertestufe (5) ein zweites Monoflop (5c) enthält, das mit derselben Flanke des Ausgangssignals des Quantisierers (2, 3) angestossen wird und dass durch Überprüfung des Ausgangssignalzustandes bei Ablauf der durch das zweite Monoflop (5c) vorgegebenen Impulsdauer ($\Delta t_2$) ebenfalls die Taktperiode des Ausgangssignals überprüft wird, wobei die durch das zweite Monoflop (5c) vorgegebene Impulsdauer ($\Delta t_2$) kürzer ist als die durch das erste Monoflop (5a) vorgegebene Impulsdauer ($\Delta t_1$) und dass die Vergrösserung des Eingangssignals des Stromeingangs des Multiplizierers (1) durch das erste Monoflop ausgelöst und durch das zweite Monoflop (5c) wieder aufgehoben wird.

5. Elektronischer Elektrizitätszähler nach den Ansprüchen 3 und 4, dadurch gekennzeichnet, dass der Ausgang jedes Monoflops (5a, 5d) mit dem D-Eingang je eines D-Flip-Flops (5b, 5c) verbunden ist, dass das Ausgangssignal des Quantisierers (2, 3) über einen Inverter (5e) dem Takteingang jedes D-Flip-Flops (5b, 5d) zugeführt ist, dass ein Ausgang jedes D-Flip-Flops (5b, 5d) mit je einem Eingang eines RS-Flip-Flops (5f) verbunden ist und dass ein Ausgang des RS-Flip-Flops (5f) den Eingangskreis (6) und den Quantisierer (2, 3) ansteuert.

**Claims**

1. An electronic electricity meter comprising a multiplier (1) for current and voltage, followed by a quantizer (2, 3) with a switchable conversion ratio and a counting device (4), and the current input of the multiplier being preceded by an input circuit (6) with a switchable conversion ratio, characterised in that the quantizer (2, 3) is followed by an analysing stage (5) for the clock pulse period of its output voltage, and that the analysing stage (5) controls the input circuit (6) and the switching input of the quantizer (2, 3) such that above a limit value of the clock pulse period the input signal of the current input of the multiplier (1) is increased and the conversion ratio of the quantizer (2, 3) raised to such an extent that the effect of the increase in the input signal is compensated.

2. An electronic electricity meter as claimed in claim 1, comprising a current transformer (7) which precedes the current input of the multiplier (1), characterised in that the input circuit (6) consists of two load resistors (6b, 6c) which can be selctively connected to the secondary side of the current transformer (7) under the control of the analysing stage (5).

3. An electronic electricity meter as claimed in claim 1 or 2, characterised in that the analysing stage (5) comprises a first monostable flip-flop (5a) contacted by each positive or negative flank of the output signal of the quantizer (2, 3) and that the clock pulse period of the output signal is checked by checking the output signal position during the expiration of the pulse duration $(\Delta t_1)$ predetermined by the monostable flip-flop (5a).

4. An electronic electricity meter as claimed in claim 3, characterised in that the analysing stage (5) comprises a second monostable flip-flop (5c) contacted by the same flank of the output signal of the quantizer (2, 3), and that the clock pulse period of the output signal is checked in similar manner by checking the output signal position during the expiration of the pulse duration $(\Delta t_2)$ predetermined by the second monostable flip-flop (5c), where the pulse duration $(\Delta t_2)$ predetermined by the second monostable flip-flop (5c) is shorter than the pulse duration $(\Delta t_1)$ predetermined by the first monostable flip-flop (5a), and that the increase of the input signal of the current input of the multiplier (1) is triggered by the first monostable flip-flop and recompensated by the second monostable flip-flop (5c).

5. An electronic electricity meter as claimed in claim 3 and 4, characterised in that the output of each monostable flip-flop (5a, 5d) is connected to the D-input of a D-type flip-flop (5b, 5e), that the output signal of the quantizer (2, 3) is supplied to the clock pulse input of each D-type flip-flop (5b, 5d) by an inverter (5e), that an input of each D-type flip-flop (5b, 5d) is connected to an input of an RS flip-flop (5f) and that an input of the RS flip-flop (5f) controls the circuit (6) and the quantizer (2, 3).

**Revendications**

1. Compteur électronique d'électricité comportant un multiplicateur (1) pour le courant et la tension, et dans lequel un quantificateur (2, 3) possédant un rapport de transformation commutable et un dispositif de comptage (4) sont branchés en aval du multiplicateur et dans lequel un circuit d'entrée (6) comportant un rapport de transmission commutable est branché en amont de l'entrée de courant du multiplicateur, caractérisé par le fait qu'un étage (5) d'évaluation de la période de cadence de tension de sortie du quantificateur (2, 3) est branché en aval de ce dernier et que l'étage d'évaluation (5) commande le circuit d'entrée (6) et l'entrée de commutation du quantificateur (2, 3) de telle sorte qu'au-dessus d'une valeur limite de la période de cadence, le signal d'entrée présent à l'entrée de courant du multiplicateur (1) est amplifié et le rapport de transformation du quantificateur (2, 3) est accru au point que l'effet de l'amplification du signal d'entrée est compensé.

2. Compteur électronique d'électricité suivant la revendication 1, comportant un transformateur d'intensité (7) branché en amont de l'entrée de courant du multiplicateur (1), caractérisé par le fait que le circuit d'entrée (6) est constitué par deux résistances de charge (6b, 6c), qui, sur la commande de l'étage d'évaluation (5), peuvent être reliées au côté secondaire du transformateur d'intensité (7).

3. Compteur électronique d'électricité suivant la revendication 1 ou 2, caractérisé par le fait que l'étage d'évaluation (5) contient un premier multivibrateur monostable (5a) qui est déclenché par chaque flanc positif ou négatif du signal de sortie du quantificateur (2, 3) et que la période de cadence du signal de sortie est contrôlée au moyen d'un contrôle de l'état du signal de sortie au bout de l'écoulement de la durée d'impulsion $(\Delta t_1)$ prédéterminée par le multivibrateur monostable (5a).

4. Compteur électronique d'électricité suivant la revendication 3, caractérisé par le fait que l'étage d'évaluation (5) contient un second multivibrateur monostable (5c), qui est déclenché par le même flan du signal de sortie du quantificateur (2, 3) et que, également, la période de cadence du signal de sortie est contrôlée par l'intermédiaire du contrôle de l'état du signal de sortie après l'écoulement de la durée d'impulsion $(\Delta t_2)$ prédéterminée par le second multivibrateur monostable (5c), la durée d'impulsion $(\Delta t_2)$ prédéterminée par le second multivibrateur monostable (5c) étant inférieure à la durée d'impulsion $(\Delta t_1)$ prédéterminée par le premier multivibrateur monostable (5a), et que l'amplification du signal d'entrée présent à l'entrée de courant du multiplicateur (1) est déclenchée par le premier multivibrateur monostable et est à nouveau supprimée par le second multivibrateur monostable (5c).

5. Compteur électronique d'électricité suivant les revendications 3 et 4, caractérisé par le fait que la sortie de chaque multivibrateur monostable (5a, 5b) est reliée à l'entrée D d'une bascule bistable respective de type D (5b, 5c), que le signal de sortie du quantificateur (2, 3) est envoyé par l'intermédiaire d'un inverseur (5e) à l'entrée de cadence de chaque bascule bistable de type D (5b, 5d), qu'une sortie de chaque bascule bistable (5b, 5d) est reliée à une entrée respective d'une bascule bistable de type RS (5f) et qu'une sortie de la bascule bistable de type (RS) (5f) commande le circuit d'entrée (6) et le quantificateur (2, 3).

FIG 1

FIG 2

FIG 3 $U_e$

FIG 4 $U_{5a}$

FIG 5 $U_{5b}$

FIG 6 $U_{5c}$

FIG 7 $U_{5d}$

FIG 8 $U_{5f}$

$J < 1\% \ J_N$  $J = 1\% \ J_N$  $J = 2\% \ J_N$  $J = 3\% \ J_N$  $J > 3\% \ J_N$

$\Delta t_1$

$\Delta t_2$

0 137 942